# EUROPEAN PATENT SPECIFICATION

(11) **EP 4 286 928 B1**
(45) Date of publication and mention of the grant of the patent: **28.01.2026**
(21) Application number: 23176271.7
(22) Date of filing: 31.05.2023
(51) Int. Cl.: G02F 1/1333, H10K 50/84, H10K 50/86, B32B 27/28, B32B 27/30, H10K 59/80, H10K 50/87, B32B 15/08, B32B 27/20

(54) **DISPLAY DEVICE AND METHOD OF MANUFACTURING THE SAME**
ANZEIGEVORRICHTUNG UND VERFAHREN ZUR HERSTELLUNG DAVON
DISPOSITIF D'AFFICHAGE ET SON PROCÉDÉ DE FABRICATION

(30) Priority: 02.06.2022 KR 20220067303
(43) Date of publication of application: 06.12.2023
(73) Proprietor: Samsung Display Co., Ltd., Yongin-si, Gyeonggi-do 17113 (KR)
(72) Inventor: JUNG, Suk Won, Giheung-Gu, Yongin-si, Gyeonggi-Do (KR); KIM, Youngdo, Giheung-Gu, Yongin-si, Gyeonggi-Do (KR); PARK, Junehyoung, Giheung-Gu, Yongin-si, Gyeonggi-Do (KR); YOU, Junwoo, Giheung-Gu, Yongin-si, Gyeonggi-Do (KR); LEE, Changmoo, Giheung-Gu, Yongin-si, Gyeonggi-Do (KR)
(74) Representative: Dr. Weitzel & Partner

(56) References cited:
- GB-A- 2 580 211
- US-A1- 2019 280 224
- US-A1- 2020 295 302
- US-A1- 2020 325 952

## Description

### BACKGROUND

### 1. Technical Field

The invention relates to a display device including a reflective layer and a protective layer, which are disposed under a display panel, and a method of manufacturing the display device.

### 2. Description of the Related Art

Various types of display devices that are applied to multimedia devices, such as television sets, mobile phones, tablet computers, game units, or the like, are being developed. Display devices include a variety of functional layers to provide color images having superior quality to users.

In recent years, studies on a display device having a thin thickness are being conducted to implement various types of display devices, such as a display device including a curved surface, a rollable display device, or a foldable display device. The display device having a thin thickness is implemented by reducing the number of functional layers and providing a functional layer having multiple functions.

When implementing the display device with a thin thickness, it is required for the display device to have an impact resistance property. To this end, researches on display devices with excellent impact resistance and optical properties are being conducted.

US 2020/0325952 A1 discloses a display device with a shock absorbing layer including a light blocking function under a display panel. The features disclosed in US 2020/0325952 A1 have been summarized in the preamble of the independent claims. Further reference is made to US 2019/0280224 A1 and US 2020/0295302 A1.

### SUMMARY

The present invention is defined by the independent claims. The dependent claims describe preferred embodiments.

The invention provides a display device with improved impact resistance, visibility, and reliability. The invention also provides a method of manufacturing a display device with improved impact resistance, visibility, and reliability.

A display device according to the present invention includes a display panel, a protective film disposed under the display panel, a reflective layer disposed under the protective film and including a metal, and a protective layer disposed under the reflective layer and provided in a single layer. The protective layer includes a base portion, a light absorbent, and a polymer bead. The light absorbent includes a black pigment or a black dye and is dispersed in the base portion.

The protective layer may be disposed directly on a lower surface of the reflective layer.

The base portion may include an acrylic resin or a silicone resin.

The light absorbent may absorb visible light.

The reflective layer may be disposed directly on a lower surface of the protective film.

The reflective layer may include at least one of Ag, Mg, Cu, Al, Pt, Pd, Au, Ni, Nd, Ir, Cr, Li, Ca, Mo, Ti, and W.

The display device may further include a heat dissipation layer disposed under the protective layer.

The protective layer may include about 20 vol% or more of the light absorbent in relation to a total volume of the protective layer.

The protective layer may include about 20 vol% or more of the polymer bead in relation to a total volume of the protective layer.

The polymer bead may include a shell portion including a polymer, and a core portion including gas and surrounded by the shell portion.

A thickness of the protective layer may be equal to or greater than about 150 micrometers and equal to or less than about 200 micrometers.

An optical density of the protective layer may be equal to or greater than about 3.

Embodiments of the invention provide a display device that includes a display panel, a window disposed on the display panel, and a lower member disposed under the display panel. The lower member includes a protective film, a reflective layer disposed directly on a lower portion (or surface) of the protective film and including a metal, and a protective layer disposed directly on a lower portion (or surface) of the reflective layer. The protective layer includes a base portion, a light absorbent, and a polymer bead. The light absorbent includes a black pigment or a black dye and is dispersed in the base portion.

The reflective layer may include at least one of Ag, Mg, Cu, Al, Pt, Pd, Au, Ni, Nd, Ir, Cr, Li, Ca, Mo, Ti, and W.

The protective layer may include about 20 vol% or more of the light absorbent in relation to a total volume of the protective layer.

The protective layer may include about 20 vol% or more of the polymer bead in relation to a total volume of the protective layer.

The polymer bead may include a shell portion including a polymer and a core portion including gas and surrounded by the shell portion.

An optical density of the protective layer may be equal to or greater than about 3. The optical density (OD) may be defined as the logarithmic ratio of the intensity of incident light (lo) to the intensity of the transmitted light (lt) passing through the protective layer (OD= log₁₀ lo / lt).

The invention provides a method of manufacturing a display device. The method includes providing a display panel, providing a protective film on the display panel, providing a reflective layer including a metal on the protective film, and providing a protective layer on the reflective layer. The providing of the protective layer includes providing a coating composition including a base resin, a light absorbent including a black pigment or a black dye, a polymer bead, and a photoinitiator on the reflective layer to form a coating layer, and irradiating ultraviolet light to the coating layer from above a surface of the coating layer spaced apart from the reflective layer to form the protective layer.

The irradiating of the ultraviolet light to form the protective layer may include providing direct light directly to the surface of the coating layer, and providing indirect light provided by the direct light passing through the coating layer and reflected by the reflective layer.

The photoinitiator may be activated by the ultraviolet light.

The method may further include providing a heat dissipation layer on the protective layer after the providing of the protective layer on the reflective layer.

The reflective layer may include at least one of Ag, Mg, Cu, Al, Pt, Pd, Au, Ni, Nd, Ir, Cr, Li, Ca, Mo, Ti, and W.

The providing of the reflective layer may include depositing the metal or coating the metal in a paste on the protective film.

A thickness of the coating layer may be equal to or greater than about 150 micrometers and equal to or less than about 200 micrometers.

According to the invention, a display device includes a protective layer disposed under a display panel and including a light absorbent and a polymer bead, and thus, the display device may have an excellent impact resistance and reliability.

According to the invention, a method of manufacturing a display device includes providing a protective layer under a reflective layer. The display device includes a protective layer including a light absorbent and a polymer bead, and the protective layer may be cured by indirect light as well as direct light.

### BRIEF DESCRIPTION OF THE DRAWINGS

The above and other advantages of the disclosure will become readily apparent by reference to the following detailed description when considered in conjunction with the accompanying drawings wherein:
FIG. 1 is a perspective view of a display device according to an embodiment of the disclosure;
FIG. 2 is an exploded perspective view of a display device according to an embodiment of the disclosure;
FIG. 3 is a schematic cross-sectional view of a display device according to an embodiment of the disclosure;
FIG. 4 is a schematic cross-sectional view of a display module according to an embodiment of the disclosure;
FIG. 5 is a schematic cross-sectional view of a display module according to an embodiment of the disclosure;
FIG. 6 is a flowchart of a method of manufacturing a display device according to an embodiment of the disclosure;
FIG. 7 is a schematic cross-sectional view illustrating a process of the manufacturing method of the display device according to an embodiment of the disclosure;
FIG. 8 is a flowchart of a process of a method of manufacturing a display device according to an embodiment of the disclosure;
FIG. 9 is a schematic cross-sectional view illustrating a process of the manufacturing method of the display device according to an embodiment of the disclosure;
FIG. 10 is a schematic cross-sectional view illustrating a process of the manufacturing method of the display device according to an embodiment of the disclosure; and
FIG. 11 is a flowchart of a method of manufacturing a display device according to an embodiment of the disclosure.

### DETAILED DESCRIPTION OF THE EMBODIMENTS

The disclosure may be variously modified and realized in many different forms, and thus specific embodiments will be illustrated in the drawings and described in detail hereinbelow. However, the disclosure should not be limited to the specific disclosed forms.

In the disclosure, it will be understood that when an element (or area, layer, or portion) is referred to as being "on", "connected to" or "coupled to" another element or layer, it can be directly on, connected or coupled to the other element or layer or intervening elements or layers may be present. To this end, the term "connected" may refer to physical, electrical, and/or fluid connection, with or without intervening elements.

However, when an element is referred to as being "directly connected" to another element, there are no intervening elements present between a layer, film region, or substrate and another layer, film, region, or substrate. For example, the term "directly connected" may mean that two layers or two members are disposed without employing additional adhesive therebetween.

Like numerals refer to like elements throughout. In the drawings, the thickness, ratio, and dimension of components are exaggerated for effective description of the technical content.

In the specification and the claims, the phrase "at least one of" is intended to include the meaning of "at least one selected from the group of" for the purpose of its meaning and interpretation. For example, "at least one of A and B" may be understood to mean "A, B, or A and B." In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

It will be understood that, although the terms first, second, etc. may be used herein to describe various elements, these elements should not be limited by these terms. These terms are only used to distinguish one element from another element. Thus, a first element discussed below could be termed a second element without departing from the teachings of the disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Hereinafter, a display device and a method of manufacturing the display device will be described with reference to accompanying drawings.

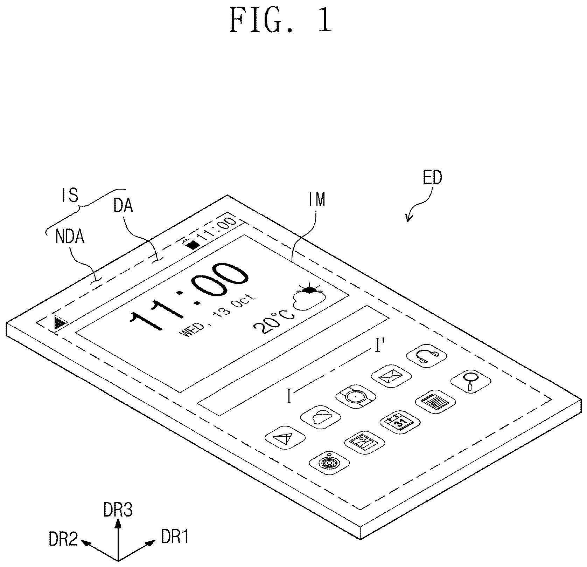

FIG. 1 is a perspective view of a display device ED according to an embodiment of the disclosure. FIG. 1 shows a mobile electronic device as a representative example of the display device ED. However, the display device ED may be applied to a large-sized electronic item, such as a television set, a monitor, an outdoor billboard, and the like, and a small and medium-sized electronic item, such as a personal computer, a notebook computer, a personal digital assistant, a car navigation unit, a game unit, a smartphone, a tablet computer, a camera, and the like. The display device ED may be also applied to other electronic devices.

The display device ED may have a hexahedron shape with a thickness in a third directional axis DR3 on a plane defined by a first directional axis DR1 and a second directional axis DR2 crossing the first directional axis DR1. However, the disclosure is not limited thereto, and the display device ED may have a variety of shapes.

According to an embodiment, upper (or front) and lower (or rear) surfaces of each member may be defined with respect to a direction in which an image IM is displayed. The front and rear surfaces may be opposite to each other in the third directional axis DR3, and a normal line direction of each of the front and lower surfaces may be substantially parallel to the third directional axis DR3.

Directions indicated by the first, second, and third directional axes DR1, DR2, and DR3 may be relative to each other and may be changed to other directions. Hereinafter, first, second, and third directions respectively correspond to directions indicated by the first, second, and third directional axes DR1, DR2, and DR3 and are assigned with the same reference numerals as those of the first, second, and third directional axes DR1, DR2, and DR3.

The display device ED may display the image IM through a display surface IS. The display surface IS may include a display area DA in which the image IM is displayed and a non-display area NDA defined adjacent to the display area DA. The image IM may not be displayed through the non-display area NDA. The image IM may include a video or a still image. FIG. 1 shows multiple application icons and a clock widget as representative examples of the image IM.

The display area DA may have a quadrangular shape. The non-display area NDA may surround the display area DA. However, they should not be limited thereto or thereby, and the shape of the display area DA and the shape of the non-display area NDA may be designed relative to each other. In another embodiment, the non-display area NDA may not be disposed on a front surface of the display device ED.

The display device ED may be flexible. The electronic device DD may be flexible. The term "flexible" used herein refers to the property of being able to be bent, and the flexible electronic device may include all structures from a structure that may be completely bent to a structure that may be bent at the scale of a few nanometers. For example, the display device ED may be a curved display device or a foldable display device. However, it should not be limited thereto or thereby. According to an embodiment, the display device ED may be rigid.

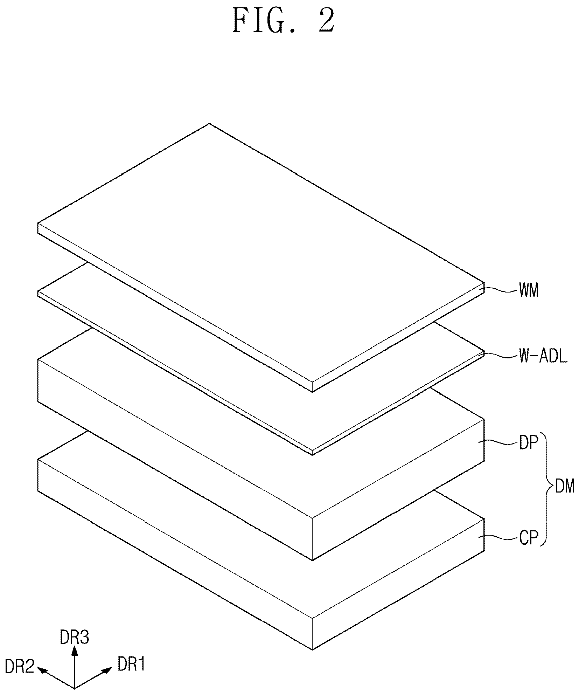

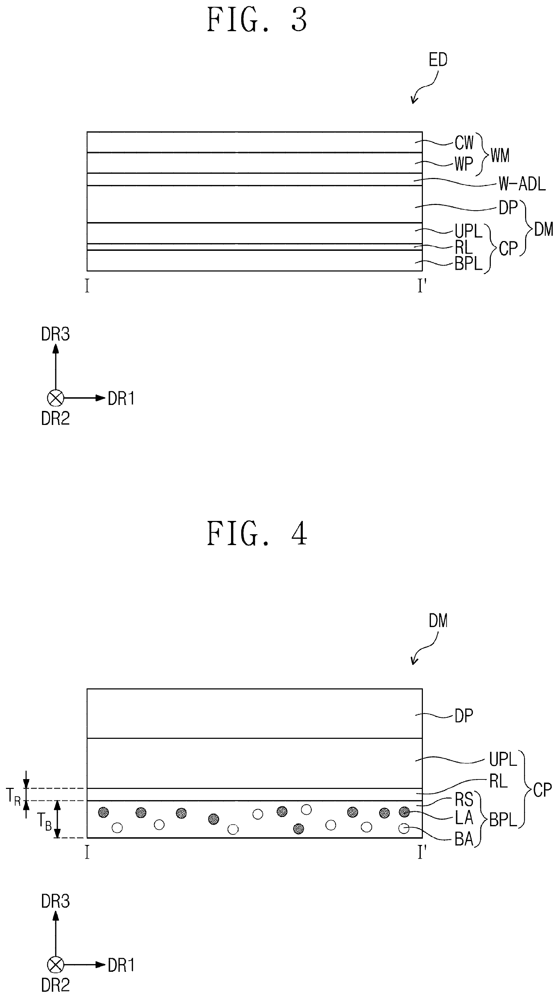

FIG. 2 is an exploded perspective view of the display device according to an embodiment of the disclosure. FIG. 3 is a schematic cross-sectional view of the display device ED according to an embodiment of the disclosure. FIG. 4 is a schematic cross-sectional view of a display module DM according to an embodiment of the disclosure.

Referring to FIGS. 2 to 4, the display device ED may include a lower member CP, a display module DM, and a window WM. The window WM may include an optically transparent insulating material. For example, the window WM may include a glass substrate or a synthetic resin film. In the case where window WM is a synthetic resin film, the window WM may include a polyimide (PI) film or a polyethylene terephthalate (PET) film.

The window WM may have a single-layer or multi-layer structure. For example, the window WM may include multiple synthetic resin films coupled to each other by an adhesive or may include a glass substrate and a synthetic resin film coupled to the glass substrate by an adhesive.

The window WM may include a glass substrate WP and a window protective film CW. The glass substrate WP may be attached to the display module DM by a window adhesive layer W-ADL. The window protective film CW may be disposed on the glass substrate WP.

The display module DM includes a display panel DP and the lower member CP. The lower member CP includes a protective film UPL, a reflective layer RL, and a protective layer BPL.

The display panel DP may include multiple pixels arranged in an area corresponding to the display area DA. The pixels may emit lights in response to electrical signals. The image IM (refer to FIG. 1) displayed by the lights from the pixels may be displayed through the display area DA (refer to FIG. 1) of the display device ED.

The display panel DP may include a display element layer (not shown). The display element layer may include an organic electroluminescent element, a quantum dot light emitting element, or a liquid crystal layer, however, the disclosure should not be limited thereto or thereby.

The display module DM includes the display panel DP, the protective film UPL, the reflective layer RL, and the protective layer BPL. The display panel DP may be disposed adjacent to the window WM. FIGS. 2 and 3 show a structure in which the window WM is disposed directly on the window adhesive layer W-ADL disposed on the display panel DP, however, the disclosure should not be limited thereto or thereby. For example, the display device ED may include at least one functional layer such as an optical layer (not shown) and a touch layer (not shown), which are disposed between the display panel DP and the window WM.

The protective film UPL is disposed under the display panel DP. The protective film UPL may be disposed directly on a lower surface of the display panel DP. However, the disclosure is not limited thereto. For example, the protective film UPL may be attached to the display panel DP by an adhesive layer (not shown).

The protective film UPL may serve as a support layer that supports the display panel DP. The protective film UPL may include an organic material. For example, the protective film UPL may include polyethylene terephthalate (PET). However, the disclosure should not be limited thereto or thereby, and materials for the protective film UPL should not be particularly limited as long as the protective film UPL supports the display panel DP.

The reflective layer RL is disposed under the protective film UPL. The reflective layer RL may be disposed directly on a lower surface of the protective film UPL. The reflective layer RL may be formed by depositing a metal on the protective film UPL using a deposition method or by coating metal paste on the protective film UPL. The reflective layer RL may have a thickness T_{R} equal to or greater than about 0.05*µ*m and equal to or less than about 0.30*µ*m*.*

The reflective layer RL includes a metal. For example, the reflective layer RL may include at least one of Ag, Mg, Cu, Al, Pt, Pd, Au, Ni, Nd, Ir, Cr, Li, Ca, Mo, Ti, and W. For example, the reflective layer RL may include Ag or AgMg. The reflective layer RL may include Ag paste. The reflective layer RL may reflect light incident thereto from the outside of the reflective layer RL. The function of the reflective layer RL will be described in detail later in the method of manufacturing the display device.

The protective layer BPL is disposed under the reflective layer RL. The protective layer BPL may be disposed directly on a lower surface of the reflective layer RL. The protective layer BPL may perform a function of blocking an external light and a function of impact resistance to protect the display panel DP from external impacts. The protective layer BPL may be directly coated on the lower surface of the reflective layer RL. A method of coating the protective layer BPL on the lower surface of the reflective layer RL will be described in detail later in the method of manufacturing the display device.

The protective layer BPL includes a base portion RS, a light absorbent LA dispersed in the base portion RS, and a polymer bead BA. For example, the base portion RS may include an acrylic resin or a silicone resin. The base portion RS may be a dispersion medium in which the light absorbent LA is dispersed. The protective layer BPL has a single-layer structure of the base portion RS in which the light absorbent LA is dispersed. For example, the protective layer BPL may be formed by a single process.

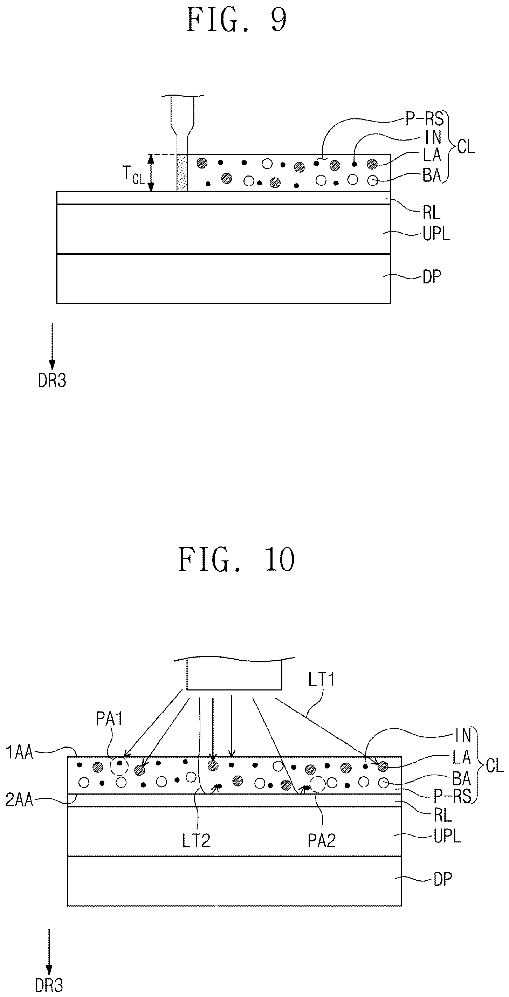

The light absorbent LA is dispersed in the base portion RS. The light absorbent LA may absorb visible light. The light absorbent LA includes a black pigment or a black dye. For example, the light absorbent LA may include a carbon black or an aniline black. However, the disclosure is not limited thereto and materials for the light absorbent LA should not be particularly limited as long as they maintain the protective layer BPL in black color. The light absorbent LA may absorb a portion of ultraviolet light. As the light absorbent LA has a property of absorbing ultraviolet light, an activation of a photoinitiator IN (refer to FIG. 9) used for polymerization of the base portion RS may decrease in the process of photocuring and forming the protective layer BPL. However, in the manufacturing method of the display device according to the disclosure, as the protective layer BPL is formed on the reflective layer RL, the protective layer BPL with a high degree of polymerization and a high degree of curing may be formed even though the light absorbent LA has the property of absorbing ultraviolet light. This will be described in detail later.

The protective layer BPL may have an optical density (OD) equal to or greater than about 3. As the protective layer BPL has an optical density (OD) equal to or greater than about 3, an amount of light reflected to the outside among lights incident into the protective layer BPL from the outside may be reduced.

The protective layer BPL includes the polymer bead BA therein. The polymer bead BA included in the protective layer BPL may have a core-shell structure. For example, the polymer bead BA may include a shell portion and a core portion surrounded by the shell portion. The core portion may contain gas. For example, the core portion may include air. The shell portion may include a polymer. As the protective layer BPL includes the polymer bead BA, the protective layer BPL may serve as a cushion layer. For example, in case that external impacts are applied to the protective layer BPL, the polymer bead BA may serve as an elastomer to absorb the external impacts, and thus, the protective layer BPL may serve as a cushion layer. Accordingly, the protective layer BPL may protect the display panel DP from external impacts.

The protective layer BPL may have a thickness T_{B} equal to or greater than about 150*µ*m and equal to or less than about 200*µ*m. In case that the thickness T_{B} of the protective layer BPL is less than about 150*µ*m, the impact resistance of the protective layer BPL may be insufficient. In case that the thickness T_{B} of the protective layer BPL is greater than about 200*µ*m, the thickness of the display device ED (refer to FIG. 1) may increase.

The protective layer BPL may include about 20 vol% or more of the light absorbent LA in relation to a total volume of the protective layer BPL. In case that the protective layer BPL includes less than about 20 vol% of the light absorbent LA in relation to the total volume of the protective layer BPL, the light blocking function of the protective layer BPL may be insufficient.

The protective layer BPL may include about 20 vol% or more of the polymer bead BA in relation to the total volume of the protective layer BPL. In case that the protective layer BPL includes less than about 20 vol% of the polymer bead BA in relation to the total volume of the protective layer BPL, the impact resistance of the protective layer BPL may be insufficient.

The base portion RS may serve as a matrix in which the polymer bead BA and the light absorbent LA are dispersed. The base portion RS may be formed by polymerizing and curing a base resin P-RS (refer to FIG. 9) by the photoinitiator IN (refer to FIG. 9) in a coating composition (refer to FIG. 9).

According to the embodiment, the display device ED (refer to FIG. 1) includes the display panel DP, the reflective layer RL disposed under the display panel DP, and the protective layer BPL including the base portion RS, the light absorbent LA, and the polymer bead BA and provided under the reflective layer RL as a single layer. Accordingly, the protective layer BPL may substantially simultaneously have light blocking characteristics and impact resistance characteristics. Since the protective layer BPL has a thin thickness, the display device ED (refer to FIG. 1) may have thin thickness and may have sufficient reliability.

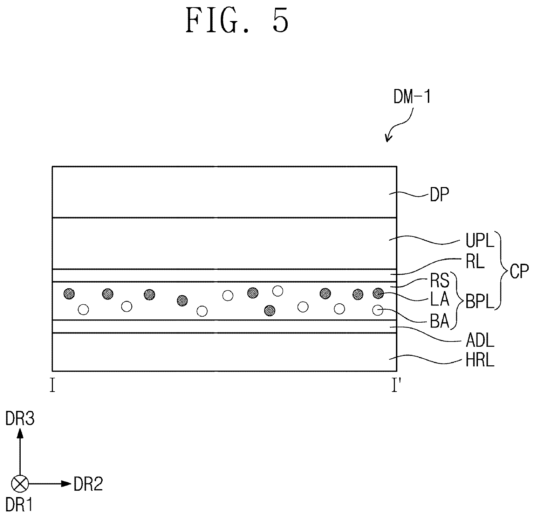

FIG. 5 is a schematic cross-sectional view of a display module DM-1 according to an embodiment of the disclosure. In FIG. 5, descriptions of the same elements as those shown in FIGS. 1 to 4 will not be repeated again, and descriptions will be focused on different features from those of FIGS. 1 to 4.

Different from the display module DM described with reference to FIGS. 1 to 4, the display module DM-1 shown in FIG. 5 may include a heat dissipation layer HRL disposed under a protective layer BPL.

Referring to FIG. 5, the display module DM-1 may include the heat dissipation layer HRL disposed under the protective layer BPL. The heat dissipation layer HRL may dissipate heat generated from members of the display device ED (refer to FIG. 1) such as the display panel DP. For example, the heat dissipation layer HRL may include copper (Cu). The heat dissipation layer HRL may be formed through a process different from that of the protective layer BPL.

The display module DM-1 may include an adhesive layer ADL disposed between the protective layer BPL and the heat dissipation layer HRL. The heat dissipation layer HRL may be attached to the protective layer BPL by the adhesive layer ADL. The adhesive layer ADL may be a pressure sensitive adhesive (PSA) film or an adhesive resin layer.

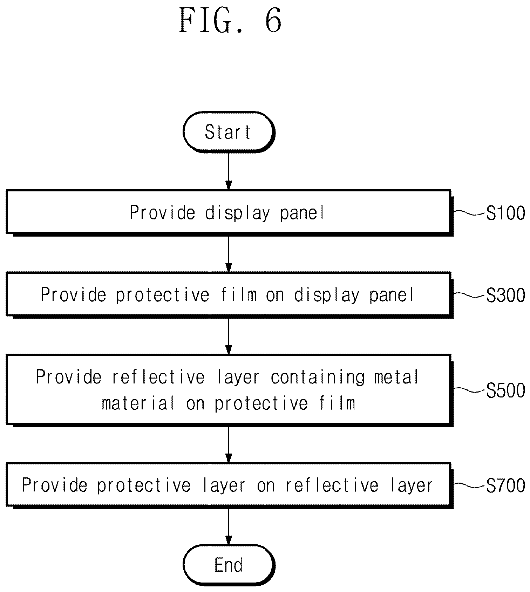

Hereinafter, the manufacturing method of the display device will be described in detail with reference to FIGS. 6 to 10. Features of the display device described with reference to FIGS. 1 to 5 will not be repeated again, and descriptions will be focused on the method of manufacturing the display device.

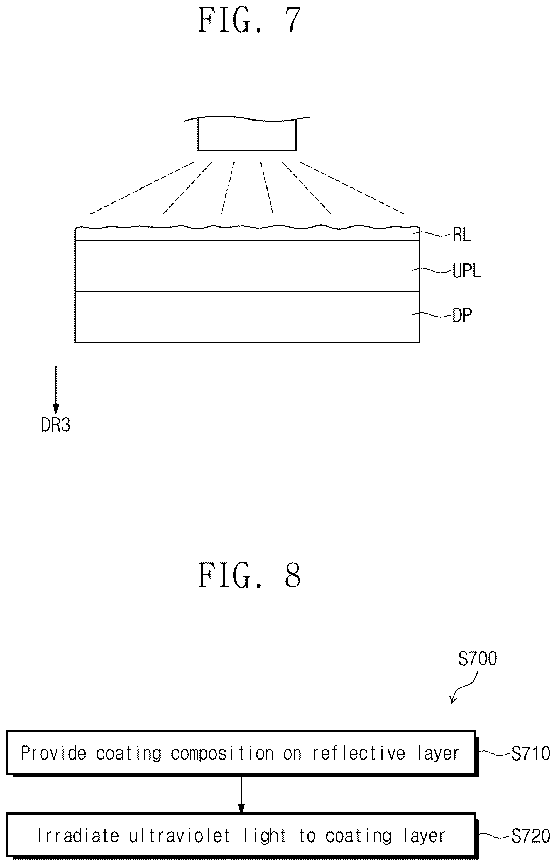

FIG. 6 is a flowchart of the method of manufacturing the display device according to an embodiment of the disclosure. FIG. 7 is a schematic cross-sectional view illustrating a process of the manufacturing method of the display device according to an embodiment of the disclosure.

Referring to FIG. 6, the manufacturing method of the display device includes providing a display panel (S100), providing a protective film on the display panel (S300), providing a reflective layer including a metal on the protective film (S500), and providing a protective layer on the reflective layer (S700).

FIG. 7 is a schematic cross-sectional view showing a process of providing a reflective layer including a metal on the protective film. Referring to FIG. 7, the providing of the reflective layer including a metal on the protective film (S500) may include depositing a metal on the protective film UPL or providing metal paste (or a metal in a paste) on the protective film UPL to form a reflective layer RL on the protective film UPL.

FIG. 8 is a flowchart of processes of the manufacturing method of the display device according to an embodiment of the disclosure. FIG. 9 is a schematic cross-sectional view illustrating a process of the manufacturing method of the display device according to an embodiment of the disclosure. FIG. 10 is a schematic cross-sectional view illustrating a process of the manufacturing method of the display device according to an embodiment of the disclosure. Referring to FIG. 8, the providing of the protective layer on the reflective layer (S700) includes providing a coating composition on the reflective layer RL to form a coating layer CL on the reflective layer RL (S710) and irradiating ultraviolet lights LT1 and LT2 onto the coating layer CL to form a protective layer BPL (S720). Thus, the coating layer CL is a layer formed by providing the coating composition on the reflective layer RL as shown in FIG. 9 by reference sign CL.

FIG. 9 is a schematic cross-sectional view showing the process of the providing of a coating composition on the reflective layer RL (S710). Referring to FIG. 9, the coating composition provided on the reflective layer RL (S710) includes a base resin P-RS, a light absorbent LA, a polymer bead BA, and a photoinitiator IN. The coating composition may be directly coated on the reflective layer RL in the providing of a coating composition on the reflective layer RL (S710). The coating layer CL is formed by the coating composition coated on the reflective layer RL. The providing of a coating composition on the reflective layer RL (S710) may include coating the coating composition on the reflective layer RL to form the coating layer CL on the reflective layer RL with a thickness T_{CL} equal to or greater than about 150*µ*m and equal to or less than about 200*µ*m.

The coating composition includes a photoinitiator IN. The photoinitiator IN may be activated by ultraviolet light. In case that the photoinitiator IN is activated by ultraviolet light, the base resin P-RS included in the coating composition is polymerized and cured, and thus, the protective layer BPL is formed. For example, the photoinitiator IN may be a triazine-based photoinitiator, an acetophenone-based photoinitiator, a benzophenone-based photoinitiator, a thioxanthone-based photoinitiator, a benzoin-based photoinitiator, a phosphorus-based photoinitiator, an oxime-based photoinitiator, or mixtures thereof. However, the disclosure should not be limited thereto or thereby.

The coating composition includes a polymer bead BA. The polymer bead BA may have a core-shell structure. The polymer bead BA may have a structure in which the core portion is gas, and the shell portion is polymer.

Referring to FIG. 10, the irradiating of the ultraviolet lights LT1 and LT2 to the coating layer CL to form a protective layer BPL (S720) includes irradiating the ultraviolet lights LT1 and LT2 to the coating layer CL from above a surface of the coating layer CL, which is spaced apart from the reflective layer RL. The irradiating of the ultraviolet lights LT1 and LT2 to the coating layer CL may include activating the photoinitiator IN and curing the coating layer CL to form the protective layer BPL (refer to FIG. 4). The ultraviolet lights LT1 and LT2 may have a wavelength equal to or greater than about 300nm and equal to or less than about 400nm.

In the irradiating of the ultraviolet lights LT1 and LT2 to the coating layer CL from above a surface of the coating layer CL, which is spaced apart from the reflective layer RL, (S720), direct light LT1 may be directly irradiated to the surface of the coating layer CL from the outside, and the direct light LT1 may be reflected by the reflective layer RL after passing through the coating layer CL and may be provided to the coating layer CL as indirect light LT2.

The direct light LT1 may activate the photoinitiator IN dispersed in a first portion PA1 of the coating layer CL, which is spaced apart from the reflective layer RL. Due to the light absorbent LA included in the coating layer CL, an amount of the direct light LT1 that reaches a second portion PA2 of the coating layer CL, which is adjacent to the reflective layer RL, may be reduced. Accordingly, an activation degree of the photoinitiator IN dispersed in the second portion PA2 of the coating layer CL, which is adjacent to the reflective layer RL, may be smaller than an activation degree of the photoinitiator IN dispersed in the first portion PA1. In case that the activation degree of the photoinitiator IN dispersed in the second portion PA2 is smaller than the activation degree of the photoinitiator IN dispersed in the first portion PA1, the degree of curing of the second portion PA2 may be relatively small. Thus, creases may occur in the protective layer BPL (refer to FIG. 4) at a portion corresponding to the second portion PA2, and a reliability of the protective layer may be reduced.

According to the manufacturing method of the display device, the photoinitiator IN dispersed in the second portion PA2 may be activated by the indirect light LT2 reflected by the reflective layer RL. According to the manufacturing method of the display device, even though the direct light LT1 is irradiated to a first surface 1AA of the coating layer CL spaced apart from the reflective layer RL and a portion of the direct light LT1 is absorbed by the light absorbent LA, a second surface 2AA of the coating layer CL, which is adjacent to the reflective layer RL, may be cured by the indirect light LT2. For example, since the manufacturing method of the display device includes the activating of the photoinitiator IN using the indirect light LT2, the protective layer BPL (refer to FIG. 4) with excellent reliability may be formed on the reflective layer RL.

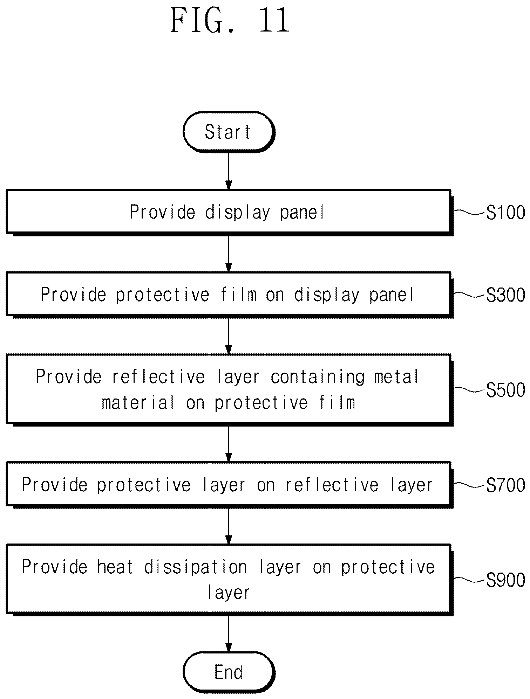

FIG. 11 is a flowchart of the manufacturing method of the display device according to an embodiment of the disclosure. The manufacturing method of the display device may include providing a heat dissipation layer HRL on the protective layer BPL (S900) after the providing of the protective layer (S700). The heat dissipation layer HRL may include copper.

As the display device includes a protective layer that includes the base portion, the light absorbent, and the polymer bead and is provided in a single layer, the display device may have a thin thickness while having a superior impact resistance, visibility, and reliability.

The manufacturing method of the display device includes providing a reflective layer and the forming a protective layer on the reflective layer. The forming of the protective layer on the reflective layer includes providing a coating composition including a base resin, a light absorbent, a polymer bead, and a photoinitiator on the reflective layer and irradiating ultraviolet light to a surface of a coating layer, which is spaced apart from the reflective layer. Accordingly, the coating layer in black color may be sufficiently cured by a direct light and an indirect light using the reflective layer, and thus, the display device may have a thin thickness while having a superior impact resistance, visibility, and reliability.

## Claims

1. A display device (ED) comprising:
a display panel (DP);
a protective film (UPL) disposed under the display panel (DP); and
a protective layer (BPL) provided in a single layer, wherein
the protective layer (BPL) comprises:
a base portion (RS);
a light absorbent (LA); and
a polymer bead (BA), and
the light absorbent (LA) comprises a black pigment or a black dye and is dispersed in the base portion (RS); **characterized in that** the display device (ED) further comprises a reflective layer (RL) disposed under the protective film (UPL) and comprising a metal; wherein the protective layer (BPL) is disposed under the reflective layer (RL).

2. The display device (ED) of claim 1, wherein the protective layer (BPL) is disposed directly on a lower surface of the reflective layer (RL).

3. The display device (ED) of claim 1 or 2, wherein the base portion (RS) comprises an acrylic resin or a silicone resin.

4. The display device (ED) of at least one of claims 1 to 3, wherein the light absorbent (LA) absorbs visible light.

5. The display device (ED) of at least one of claims 1 to 4, wherein the reflective layer (RL) is disposed directly on a lower surface of the protective film (UPL).

6. The display device (ED) of at least one of claims 1 to 5, wherein the reflective layer (RL) comprises at least one of Ag, Mg, Cu, Al, Pt, Pd, Au, Ni, Nd, Ir, Cr, Li, Ca, Mo, Ti, and W.

7. The display device (ED) of at least one of claims 1 to 6, further comprising:
a heat dissipation layer (HRL) disposed under the protective layer (BPL).

8. The display device (ED) of at least one of claims 1 to 7, wherein the protective layer (BPL) comprises about 20 vol% or more of the light absorbent (LA) in relation to a total volume of the protective layer (BPL).

9. The display device (ED) of at least one of claims 1 to 8, wherein the protective layer (BPL) comprises about 20 vol% or more of the polymer bead (BA) in relation to a total volume of the protective layer (BPL).

10. The display device (ED) of at least one of claims 1 to 9, wherein the polymer bead (BA) comprises:
a shell portion comprising a polymer; and
a core portion comprising gas and surrounded by the shell portion.

11. The display device (ED) of at least one of claims 1 to 10, wherein a thickness of the protective layer (BPL) is equal to or greater than about 150 micrometers and equal to or less than about 200 micrometers.

12. The display device (ED) of at least one of claims 1 to 11, wherein an optical density of the protective layer (BPL) is equal to or greater than about 3.

13. The display device (ED) of at least one of claims 1 to 12, further comprising:
a window (WM) disposed on the display panel (DP); and
a lower member (CP) disposed under the display panel (DP), wherein
the lower member (CP) comprises:
the protective film (UPL);
the reflective layer (RL) disposed directly on a lower surface of the protective film (UPL) and comprising the metal; and
the protective layer (BPL) disposed directly on a lower surface of the reflective layer (RL).

14. A method of manufacturing a display device (ED), especially a display device (ED) according to at least one of claims 1 to 13, comprising:
providing a display panel (DP);
providing a protective film (UPL) on the display panel (DP); and
providing a protective layer (BPL),
wherein the providing of the protective layer (BPL) comprises:
providing a coating composition comprising a base resin (P-RS), a light absorbent (LA) comprising a black pigment or a black dye, a polymer bead (BA), and a photoinitiator (IN) to form a coating layer (CL); and
irradiating ultraviolet light (LT1, LT2) to the coating layer (CL) to form
the protective layer (BPL), **characterized in that** the method further comprises: providing a reflective layer (RL) comprising metal on the protective film (UPL); wherein the protective layer (BPL) is provided on the reflective layer (RL); wherein the providing of the protective layer (BPL) further comprises: providing the coating composition on the reflective layer (RL) to form the coating layer (CL); and irradiating the ultraviolet light (LT1, LT2) from above a surface of the coating layer (CL) spaced apart from the reflective layer (RL).

15. The method of claim 14, wherein the irradiating of the ultraviolet light (LT1, LT2) to form the protective layer (BPL) comprises:
providing direct light (LT1) to the surface of the coating layer (CL); and
providing indirect light (LT2) provided by the direct light (LT1) passing through the coating layer (CL) and reflected by the reflective layer (RL).

16. The method of claim 14 or 15, wherein the photoinitiator (IN) is activated by the ultraviolet light (LT1, LT2).

17. The method of at least one of claims 14 to 16, further comprising:
providing a heat dissipation layer (HRL) on the protective layer (BPL) after the providing of the protective layer (BPL) on the reflective layer (RL).

18. The method of at least one of claims 14 to 17, wherein the providing of the reflective layer (RL) comprises depositing the metal or coating the metal in a paste on the protective film (UPL).

## Patentansprüche

1. Anzeigevorrichtung (ED) umfassend:
eine Anzeigetafel (DP);
einen unter der Anzeigetafel (DP) angeordneten Schutzfilm (UPL); und
eine Schutzschicht (BPL), die in einer einzelnen Schicht vorgesehen ist, wobei die Schutzschicht (BPL) umfasst:
einen Basisbereich (RS);
ein Lichtabsorptionsmittel (LA); und
ein Polymerkügelchen (BA), und
das Lichtabsorptionsmittel (LA) umfasst ein schwarzes Pigment oder einen schwarzen Farbstoff und ist in dem Basisbereich (RS) dispergiert; **dadurch gekennzeichnet, dass** die Anzeigevorrichtung (ED) ferner eine reflektierende Schicht (RL) umfasst, die unter dem Schutzfilm (UPL) angeordnet ist und ein Metall umfasst; wobei die Schutzschicht (BPL) unter der reflektierenden Schicht (RL) angeordnet ist.

2. Die Anzeigevorrichtung (ED) nach Anspruch 1, wobei die Schutzschicht (BPL) direkt auf einer Unterseite der reflektierenden Schicht (RL) angeordnet ist.

3. Die Anzeigevorrichtung (ED) nach Anspruch 1 oder 2, wobei der Basisbereich (RS) ein Acrylharz oder ein Silikonharz umfasst.

4. Anzeigevorrichtung (ED) nach mindestens einem der Ansprüche 1 bis 3, wobei das Lichtabsorptionsmittel (LA) sichtbares Licht absorbiert.

5. Die Anzeigevorrichtung (ED) nach mindestens einem der Ansprüche 1 bis 4, wobei die reflektierende Schicht (RL) direkt auf einer Unterseite des Schutzfilms (UPL) angeordnet ist.

6. Die Anzeigevorrichtung (ED) nach mindestens einem der Ansprüche I bis 5, wobei die reflektierende Schicht (RL) mindestens eines von Ag, Mg, Cu, Al, Pt, Pd, Au, Ni, Nd, Ir, Cr, Li, Ca, Mo, Ti und W umfasst.

7. Die Anzeigevorrichtung (ED) nach mindestens einem der Ansprüche 1 bis 6, ferner umfassend:
eine Wärmeableitungsschicht (HRL), die unter der Schutzschicht (BPL) angeordnet ist.

8. Die Anzeigevorrichtung (ED) nach mindestens einem der Ansprüche I bis 7, wobei die Schutzschicht (BPL) etwa 20 Vol.-% oder mehr des Lichtabsorptionsmittel (LA) in Bezug auf das Gesamtvolumen der Schutzschicht (BPL) umfasst.

9. Die Anzeigevorrichtung (ED) nach mindestens einem der Ansprüche I bis 8, wobei die Schutzschicht (BPL) etwa 20 Vol.-% oder mehr der Polymerkügelchen (BA) in Bezug auf das Gesamtvolumen der Schutzschicht (BPL) umfasst.

10. Die Anzeigevorrichtung (ED) nach mindestens einem der Ansprüche 1 bis 9, wobei die Polymerkügelchen (BA) umfassen:
einen Mantelbereich, der ein Polymer umfasst; und
einen Kernbereich, der Gas umfasst und von dem Mantelbereich umgeben ist.

11. Die Anzeigevorrichtung (ED) nach mindestens einem der Ansprüche 1 bis 10, wobei die Dicke der Schutzschicht (BPL) gleich oder größer als etwa 150 Mikrometer und gleich oder kleiner als etwa 200 Mikrometer ist.

12. Die Anzeigevorrichtung (ED) nach mindestens einem der Ansprüche 1 bis 11, wobei eine optische Dichte der Schutzschicht (BPL) gleich oder größer als etwa 3 ist.

13. Die Anzeigevorrichtung (ED) nach mindestens einem der Ansprüche 1 bis 12, ferner umfassend:
ein Fenster (WM), das auf der Anzeigetafel (DP) angeordnet ist; und
ein unteres Element (CP), das unter der Anzeigetafel (DP) angeordnet ist, wobei das untere Element (CP) umfasst:
den Schutzfilm (UPL);
die reflektierende Schicht (RL), die direkt auf einer Unterseite des Schutzfilms (UPL) angeordnet ist und das Metall umfasst; und
die Schutzschicht (BPL), die direkt auf einer Unterseite der reflektierenden Schicht (RL) angeordnet ist.

14. Verfahren zur Herstellung einer Anzeigevorrichtung (ED), insbesondere einer Anzeigevorrichtung (ED) gemäß mindestens einem der Ansprüche I bis 13, umfassend:
Bereitstellen einer Anzeigetafel (DP);
Bereitstellen eines Schutzfilms (UPL) auf der Anzeigetafel (DP); und
Bereitstellen einer Schutzschicht (BPL), wobei das Bereitstellen der Schutzschicht (BPL) umfasst:
Bereitstellen einer Beschichtungszusammensetzung, die ein Basis-Harz (P-RS), ein Lichtabsorptionsmittel (LA), das ein schwarzes Pigment oder einen schwarzen Farbstoff umfasst, ein Polymerkügelchen (BA) und einen Photoinitiator (IN) umfasst, um eine Beschichtungsschicht (CL) zu bilden; und
Bestrahlen der Beschichtungsschicht (CL) mit ultraviolettem Licht (LTI, LT2), um die Schutzschicht (BPL) zu bilden, **dadurch gekennzeichnet, dass** das Verfahren ferner umfasst:
Bereitstellen einer reflektierenden Schicht (RL), die Metall umfasst, auf dem Schutzfilm (UPL); wobei die Schutzschicht (BPL) auf der reflektierenden Schicht (RL) bereitgestellt wird; wobei das Bereitstellen der Schutzschicht (BPL) ferner umfasst: Bereitstellen der Beschichtungszusammensetzung auf der reflektierenden Schicht (RL), um die Beschichtungsschicht (CL) zu bilden; und
Bestrahlen der ultravioletten Strahlung (LT 1, LT2) von oberhalb einer Oberfläche der Beschichtungsschicht (CL) in einem Abstand von der reflektierenden Schicht (RL).

15. Das Verfahren nach Anspruch 14, wobei das Bestrahlen mit ultraviolettem Licht (LTI, LT2) zum Bilden der Schutzschicht (BPL) umfasst:
Bereitstellen von direktem Licht (LTI) auf der Oberfläche der Beschichtungsschicht (CL); und
Bereitstellen von indirektem Licht (LT2), das durch das direkte Licht (LTI) bereitgestellt wird, das durch die Beschichtungsschicht (CL) hindurch geht und von der reflektierenden Schicht (RL) reflektiert wird.

16. Das Verfahren nach Anspruch 14 oder 15, wobei der Photoinitiator (IN) durch das ultraviolette Licht (LTI, LT2) aktiviert wird.

17. Das Verfahren nach mindestens einem der Ansprüche 14 bis 16, ferner umfassend:
Bereitstellen einer Wärmeableitungsschicht (HRL) auf der Schutzschicht (BPL) nach dem Bereitstellen der Schutzschicht (BPL) auf der reflektierenden Schicht (RL).

18. Das Verfahren nach mindestens einem der Ansprüche 14 bis 17, wobei das Bereitstellen der reflektierenden Schicht (RL) das Abscheiden des Metalls oder das Beschichten des Metalls in einer Paste auf die Schutzfolie (UPL) umfasst.

## Revendications

1. Dispositif d'affichage (ED) comprenant :
un panneau d'affichage (DP) ;
un film protecteur (UPL) disposé sous le panneau d'affichage (DP) ; et
une couche protectrice (BPL) fournie en une seule couche, dans lequel la couche protectrice (BPL) comprend :
une partie de base (RS) ;
un absorbant de lumière (LA) ; et
une bille de polymère (BA), et
l'absorbant de lumière (LA) comprend un pigment noir ou un colorant noir et est dispersé dans la partie de base (RS) ; **caractérisé en ce que** le dispositif d'affichage (ED) comprend en outre une couche réfléchissante (RL) disposée sous le film protecteur (UPL) et comprenant un métal ; dans lequel la couche protectrice (BPL) est disposée sous la couche réfléchissante (RL).

2. Dispositif d'affichage (ED) selon la revendication 1, dans lequel la couche protectrice (BPL) est disposée directement sur une surface inférieure de la couche réfléchissante (RL).

3. Dispositif d'affichage (ED) selon la revendication 1 ou 2, dans lequel la partie de base (RS) comprend une résine acrylique ou une résine de silicone.

4. Dispositif d'affichage (ED) selon au moins l'une des revendications 1 à 3, dans lequel l'absorbant de lumière (LA) absorbe la lumière visible.

5. Dispositif d'affichage (ED) selon au moins l'une des revendications 1 à 4, dans lequel la couche réfléchissante (RL) est disposée directement sur une surface inférieure du film protecteur (UPL).

6. Dispositif d'affichage (ED) selon au moins l'une des revendications 1 à 5, dans lequel la couche réfléchissante (RL) comprend au moins l'un parmi Ag, Mg, Cu, AI, Pt, Pd, Au, Ni, Nd, Ir, Cr, Li, Ca, Mo, Ti et W.

7. Dispositif d'affichage (ED) selon au moins l'une des revendications 1 à 6, comprenant en outre :
une couche de dissipation de chaleur (HRL) disposée sous la couche protectrice (BPL).

8. Dispositif d'affichage (ED) selon au moins l'une des revendications 1 à 7, dans lequel la couche protectrice (BPL) comprend environ 20 % en volume ou plus de l'absorbant de lumière (LA) par rapport à un volume total de la couche protectrice (BPL).

9. Dispositif d'affichage (ED) selon au moins l'une des revendications 1 à 8, dans lequel la couche protectrice (BPL) comprend environ 20 % en volume ou plus de billes polymères (BA) par rapport à un volume total de la couche protectrice (BPL).

10. Dispositif d'affichage (ED) selon au moins l'une des revendications 1 à 9, dans lequel la bille de polymère (BA) comprend :
une partie coque comprenant un polymère ; et
une partie noyau comprenant du gaz et entourée par la partie coque.

11. Dispositif d'affichage (ED) selon au moins l'une des revendications 1 à 10, dans lequel une épaisseur de la couche protectrice (BPL) est égale ou supérieure à environ 150 micromètres et égale ou inférieure à environ 200 micromètres.

12. Dispositif d'affichage (ED) selon au moins l'une des revendications 1 à 11, dans lequel une densité optique de la couche protectrice (BPL) est égale ou supérieure à environ 3.

13. Dispositif d'affichage (ED) selon au moins l'une des revendications 1 à 12, comprenant en outre :
une fenêtre (WM) disposée sur le panneau d'affichage (DP) ; et
un organe inférieur (CP) disposé sous le panneau d'affichage (DP), dans lequel l'organe inférieur (CP) comprend :
le film protecteur (UPL) ;
la couche réfléchissante (RL) disposée directement sur une surface inférieure du film protecteur (UPL) et comprenant le métal ; et
la couche protectrice (BPL) disposée directement sur une surface inférieure de la couche réfléchissante (RL).

14. Procédé de fabrication d'un dispositif d'affichage (ED), notamment un dispositif d'affichage (ED) selon au moins l'une des revendications 1 à 13, comprenant :
la fourniture d'un panneau d'affichage (DP) ;
la fourniture d'un film protecteur (UPL) sur le panneau d'affichage (DP) ; et
la fourniture d'une couche protectrice (BPL),
dans lequel la fourniture de la couche protectrice (BPL) comprend :
la fourniture d'une composition de revêtement comprenant une résine de base (P-RS), un absorbant de lumière (LA) comprenant un pigment noir ou un colorant noir, une bille de polymère (BA), et un photo-initiateur (IN) pour former une couche de revêtement (CL) ; et
l'irradiation d'une lumière ultraviolette (LT1, LT2) vers la couche de revêtement (CL) pour former la couche protectrice (BPL),
**caractérisé en ce que** le procédé comprend en outre :
la fourniture d'une couche réfléchissante (RL) comprenant un métal sur le film protecteur (UPL) ; dans lequel la couche protectrice (BPL) est fournie sur la couche réfléchissante (RL) ; dans lequel la fourniture de la couche protectrice (BPL) comprend en outre : la fourniture de la composition de revêtement sur la couche réfléchissante (RL) pour former la couche de revêtement (CL) ; et
l'irradiation de la lumière ultraviolette (LT1, LT2) par le dessus d'une surface de la couche de revêtement (CL) espacée de la couche réfléchissante (RL).

15. Procédé selon la revendication 14, dans lequel l'irradiation de la lumière ultraviolette (LT1, LT2) pour former la couche protectrice (BPL) comprend :
l'application d'une lumière directe (LT1) vers la surface de la couche de revêtement (CL) ; et
l'application d'une lumière indirecte (LT2) fournie par la lumière directe (LT1) passant à travers la couche de revêtement (CL) et réfléchie par la couche réfléchissante (RL).

16. Procédé selon la revendication 14 ou 15, dans lequel le photo-initiateur (IN) est activé par la lumière ultraviolette (LT1, LT2).

17. Procédé selon au moins l'une des revendications 14 à 16, comprenant en outre :
la fourniture d'une couche de dissipation de chaleur (HRL) sur la couche protectrice (BPL) après la fourniture de la couche protectrice (BPL) sur la couche réfléchissante (RL).

18. Procédé selon au moins l'une des revendications 14 à 17, dans lequel la fourniture de la couche réfléchissante (RL) comprend le dépôt du métal ou le revêtement du métal dans une pâte sur le film protecteur (UPL).
